# EUROPÄISCHE PATENTSCHRIFT

(11) **EP 3 882 671 B1**
(45) Veröffentlichungstag und Bekanntmachung des Hinweises auf die Patenterteilung: **24.09.2025**
(21) Anmeldenummer: 21000068.3
(22) Anmeldetag: 12.03.2021
(51) Int. Cl.: G01T 1/24

(54) **III-V-HALBLEITERPIXEL-RÖNTGENDETEKTOR**
III-V SEMICONDUCTOR PIXEL X-RAY DETECTOR
DÉTECTEUR DE RAYONS X À SEMI-CONDUCTEUR III-V

(30) Priorität: 20.03.2020 DE 102020001839
(43) Veröffentlichungstag der Anmeldung: 22.09.2021
(73) Patentinhaber: AZUR SPACE Solar Power GmbH, 74072 Heilbronn (DE)
(72) Erfinder: Strobl, Gerhard, 70439 Stuttgart (DE)
(74) Vertreter: Koch Müller Patentanwaltsgesellschaft mbH

(56) Entgegenhaltungen:
- US-A1- 2015 372 047
- US-A1- 2016 307 956
- DVORYANKIN V F ET AL: "Multielement X-ray row detector on GaAs with spatial resolution of 108@mm", NUCLEAR INSTRUMENTS & METHODS IN PHYSICS RESEARCH. SECTION A, ELSEVIER BV * NORTH-HOLLAND, NL, vol. 531, no. 1-2, 21 September 2004 (2004-09-21), pages 87 - 88, XP004564749, ISSN: 0168-9002, DOI: 10.1016/J.NIMA.2004.05.097

## Beschreibung

Die Erfindung betrifft einen III-V-Halbleiterpixel-Röntgendetektor.

Aus "A Method for Adjusting the Performance of Epitaxial GaAs X-ray Detectors", Sun, G.C. and Bourgoin, J.C., Nucl. Instrum. Methods Phys. Res., Sect. A, 2003, vol. 512, pp. 355-360, aus "GaAs Schottky versus p/i/n Diodes for Pixellated X-ray Detectors", Bourgoin, J.C. and Sun, G.C., Nucl. Instrum. Methods Phys. Res., Sect. A, 2002, vol. 487, pp. 47-49, ebenso aus der DE 602 21 638 T2, ist ein Verfahren und Gerät zur Herstellung eines GaAs-Detektors für eine Röntgenstrahl-Erfassung und eine Bildaufnahme bekannt. Des Weiteren ist aus der WO 2004 816 04 A2 eine weitere GaAs-Bildaufnahmevorrichtung zur Detektion von Röntgenstrahlung bekannt.

Als Pixel eines Röntgendetektors sind p-i-n Strukturen aus GaAs aus "GaAs Pixel-Detector Technology for X-ray Medical Imaging", Lezhneva et al.,a Russlan Microelectronics, Vol, 34, No. 4, 2005, pp. 229-241, bekannt, wobei sowohl epitaktisch gewachsene als auch implantierte p+ Kontaktgebiet offenbart werden.

Ein auf Schottky-Dioden basierender Röntgendetektor auf GaAs-Basis ist aus "GaAs X-Ray System Detectors for Medical Applications", Rizzi et al., https://www.researchgate.net/publication/237780321 und aus der US 2016 / 307 956 A1 bekannt.

Weitere Röntgendetektoren sind aus Dvoryankln, V, F, et al: "Multielement X-ray row detector on GaAs with spatial resolution of 108@mm", Nuclear Instruments & Methods in Physics Research. Section A, Elsesvier BV*North-Holland, NL, Bd. 531, Nr. 1-2, 21. September 2004, Seiten 87-88 und der US 2015 / 37 20 47 A1 bekannt.

Hierbei weist der Röntgendetektor aus von Dvoryankin et al, ein Absorptionsgebiet eines ersten Leitfähigkeitstyps mit einer Oberseite und einer Unterseite, und entlang der Oberseite des Absorptionsge-biets angeordnete Halbleiterkontaktgebiete eines zweiten Leitfähigkeitstyps auf. Des Weiteren weisen die Halbleiterkontaktgebiete und das Absorptionsgebiet GaAs auf.

Nachteilig an den beschriebenen Strukturen sind die Rest- bzw. Leckströme, die bei einem Betrieb in Sperrrichtung, insbesondere über die Ränder der planaren p-n Übergänge bzw. der Mesa-Strukturen auftreten.

Hierbei weist der Röntgendetektor aus der US 2015 / 37 20 47 A1 ein Absorptionsgebiet eines ersten Leitfähigkeitstyps mit einer Oberseite und einer Unterseite, und mindestens neun in einer Matrix entlang der Oberseite des Absorptionsgebiets angeordnete Halbleiterkontaktgebiete eines zweiten Leitfähigkeitstyps und mit einer ersten Energiebandlücke auf, wobei ein metallischer Vorderseitenanschlusskontakt unterhalb der Unterseite des Absorptionsgebiets angeordnet ist und oberhalb jedes Halbleiterkontaktgebiets jeweils ein metallischer Rückseitenanschlusskontakt angeordnet ist. De Weiteren weisen oder bestehen die Halbleiterkontaktgebiete und das Absorptionsgebiet GaAs. Der Röntgendetektor weist zudem eine Halbleiterpassivierungsschicht des ersten oder des zweiten Leitfähigkeitstyp auf.

Nachteilig an den beschriebenen Strukturen sind die Rest- bzw. Leckströme, die bei einem Betrieb in Sperrrichtung, insbesondere über die Ränder der planaren p-n Übergänge bzw. der Mesa-Strukturen auftreten.

Vor diesem Hintergrund besteht die Aufgabe der Erfindung darin, eine Vorrichtung anzugeben, die den Stand der Technik weiterbildet.

Die Aufgabe wird durch einen III-V-Halbleiterpixel-Röntgendetektor mit den Merkmalen des Patentanspruchs 1 oder des Patentanspruchs 2 gelöst. Vorteilhafte Ausgestaltungen der Erfindung sind Gegenstand von Unteransprüchen.

Gemäß dem Gegenstand der Erfindung wird ein III-V-Halbleiterpixel-Röntgendetektor bereitgestellt.

In einer ersten alternativen Ausführungsform weist der III-V-Halbleiterpixel-Röntgendetektor ein Absorptionsgebiet eines ersten Leitfähigkeitstyps mit einer Oberseite und einer Unterseite sowie mindestens neun in einer Matrix entlang der Oberseite des Absorptionsgebiets angeordnete Halbleiterkontaktgebiete eines zweiten Leitfähigkeitstyps und mit einer ersten Energiebandlücke auf.

Außerdem umfasst der III-V-Halbleiterpixel-Röntgendetektor einen unterhalb der Unterseite des Absorptionsgebiets angeordneten metallischen Vorderseitenanschlusskontakt und jeweils oberhalb jedes Halbleiterkontaktgebiets einen angeordneten metallischen Rückseitenanschlusskontakt.

Des Weiteren weist der Röntgendetektor eine zu dem Absorptionsgebiet gitterangepasste Halbleiterpassivierungsschicht des ersten oder des zweiten Leitfähigkeitstyps und mit einer sich von der ersten Energiebandlücke der Halbleiterkontaktgebiete unterscheidenden Energiebandlücke auf.

Die Halbleiterpassivierungsschicht ist gebietsweise auf der Oberseite des Absorptionsgebiets angeordnet und weist zu jedem hochdotierten Hableiterkontaktgebiet entlang der Oberseite des Absorptionsgebiets einen Mindestabstand von mindestens 2 µm oder von mindestens 10 µm oder von mindestens 20 µm oder von mindestens 40 µm auf.

Eine zweite alternative Ausführungsform unterscheidet sich von der ersten Ausführungsform dahingehend, dass das Absorptionsgebiet den ersten Leitfähigkeitstyp oder den zweiten Leitfähigkeitstyp aufweist und der III-V-Halbleiterpixel-Röntgendetektor zusätzlich eine unterhalb der Unterseite des Absorptionsgebiets und oberhalb des metallischen Vorderseitenanschlusskontakts angeordnete Halbleiterkontaktschicht des ersten Leitfähigkeitstyps aufweist.

Die Halbleiterkontaktschicht weist bevorzugt eine Dotierstoffkonzentration von mindestens 1•10¹⁷ cm ⁻³ und eine Schichtdicke von 0,5 µm - 150 µm oder von 0,5 µm - 50 µm oder von 0,5 µm - 10 µm oder von 0,5 µm - 5 µm auf.

Vorzugsweise beträgt der Mindestabstand der Halbleiterpassivierungsschicht zu jedem hochdotierten Halbleiterkontaktgebiet nicht mehr als eine Schichtdicke des Absorptionsgebiets.

Es versteht sich, dass der Röntgendetektor dazu ausgelegt ist, insbesondere auf die Unterseite auftreffende Röntgenstrahlen zu detektieren.

Das Absorptionsgebiet und die Halbleiterpassivierungsschicht sowie, wenn vorhanden die Halbleiterkontaktschicht, sind vorzugsweise epitaktisch erzeugt. Die Schichten werden vorzugsweise nacheinander auf einem Aufwachssubstrat aufgewachsen.

Als Aufwachssubstrat eignet sich beispielsweise ein GaAs-Substrat oder ein Ge-Substrat, z.B. mit einer InGaAs-Schicht mit ca. 1 Prozent In zum Ausgleichen eines Gitterkonstantenunterschieds zwischen Germanium und Galliumarsenid. Das Aufwachssubstrat umfasst In einer anderen Ausführungsform eine Substratschicht sowie eine Pufferschicht.

Die Pufferschicht dient zum Ausgleich eines Unterschieds zwischen den Gitterkonstanten von Substrat und aktiven Epitaxie-Schichten. Um GaAs-Schichten auf einem Ge-Substrat aufzuwachsen wird beispielsweise eine InGaAs-Pufferschicht mit einem sich schrittweise oder kontinuierlich Ändernden In Anteil verwendet.

Das Aufwachssubstrat, also z.B. das GaAs-Substrat oder das Ge-Substrat und/oder eine Pufferschicht, wird anschließend durch Schleifen und / oder Ätzen und / oder andere Prozesse, z.B. Ablösen, bevorzugt vollständig gegebenenfalls auch nur teilweise entfernt.

Beispielsweise wird in einem ersten Ätzschritt das Ge-Substrat entfernt, wobei die Pufferschicht als Ätzstoppschicht dient, und danach mittels eines weiteren Ätzprozesses, z.B. jeweils nasschemisches Ätzen, die Pufferschicht von dem photonischen GaAs-Bauelement entfernt.

Alternativ wird das Aufwachssubstrat oder das Aufwachssubstrat sowie die Pufferschicht mittels eines kombinierten Schleif- und nachgeschalteten Ätzprozess entfernt. So kann der Großteil des Materialabtrags mittels Schleifen vorgenommen werden.

In einer weiteren Ausführungsform wird während eines Herstellprozesses des stapelförmigen III-V-Halbleiterbauelements eine zusätzliche Ätzstoppschicht unterhalb des Absorptionsgebiets oder, wenn vorhanden, unterhalb der Halbleiterkontaktschicht eingefügt.

Die Ätzstoppschicht wird beispielsweise zwischen dem Absorptionsgebiet und einer Pufferschicht oder einer Substratschicht oder zwischen der Halbleiterkontaktschicht und einer Pufferschicht oder einer Substratschicht oder zwischen einer Pufferschicht und einer Substratschicht erzeugt.

Die Ätzstoppschicht ermöglicht ein sehr kontrolliertes Ablösen der Substratschicht und/oder der Pufferschicht oder nur der Substratschicht mittels eines Ätzprozesses, z.B. nasschemisches Ätzen.

Insbesondere ermöglicht es die Ätzstoppschicht, Substrat und/oder Pufferschicht gegebenenfalls ganz ohne einen mechanischen Schleifprozess und sehr kontrolliert zu entfernen. Alternativ wird der Großteil des Substrats durch Schleifen entfernt und der verbleibende Rest durch nasschemisches Ätzen bis zu der Ätzstoppschicht.

Die Ätzstoppschicht selbst kann danach auch entfernt werden. Die Ätzstoppschicht weist eine starke chemische Anisotropie gegenüber den angrenzenden Schichten auf, das heißt die Ätzrate für die Ätzstoppschicht und die anschließende Schicht unterscheiden sich mindestens um einen Faktor 10.

Die Ätzstoppschicht besteht üblicherweise aus GaInP oder AlGaAs und die umgebenden Schichten aus GaAs oder GaInAs. Die entfernten Schichten sind in dem finalen Bauelement nicht mehr vorhanden.

Alternativ zu dem vollständigen Entfernen des Aufwachssubstrats wird das Aufwachssubstrat, z.B. ein mit dem zweiten Leitfähigkeitstyp dotiertes GaAs-Substrat, nur teilweise entfernt, so dass eine verbleibende dünne Schicht hochdotierte Halbleiterkontaktschicht ausbildet.

Die Halbleiterkontaktgebiete sind in einer ersten alternativen Ausführungsform als wannenförmige, in das Absorptionsgebiet hinein ragende Gebiete ausgebildet und beispielsweise durch eine Implantation erzeugt.

In einer anderen alternativen Ausführungsform sind die Halbleiterkontaktgebiete jeweils als Mesa-Struktur ausgebildet. Vorzugsweise sind die Mesa-Strukturen oberhalb der Oberseite des Absorptionsgebiets angeordnet und beispielsweise mittels wenigstens eines Maskenprozesses sowie mittels Ätz- und Abscheideprozessen erzeugt sind.

In einer Weiterbildung sind die Mesa-Strukturen auf dem Absorptionsgebiet angeordnet.

In einer Weiterbildung sind die Mesa-Strukturen jeweils auf einer Zwischenschicht ausgebildet, wobei die jeweiligen Zwischenschichten die jeweiligen Halbleiterkontaktgebiete von dem gemeinsamen Absorptionsgebiet beabstan-den.

Die Halbleiterkontaktgebiete, das Absorptionsgebiet und so vorhanden die Halbleiterkontaktschicht weisen erfindungsgemäß GaAs auf oder bestehen daraus.

In einer weiteren Ausführungsform weist der Röntgendetektor zusätzliche Halbleiterschichten aus anderen Halbleitermaterialien oder zusätzliche Schichten aus anderen nicht-Halbleiter-Materialien, z.B. eine Nitridschicht und / oder eine Oxidschicht und / oder eine Oxynitridschicht und / oder eine Polyimidschicht als weitere Passivierungsschicht, auf.

Es sei angemerkt, dass mit dem Ausdruck "besteht aus" eine Verbindung aus den genannten Stoffen ohne weitere III-V Elemente verstanden wird, jedoch Dotierstoffe, wie beispielsweise Zink oder Silizium oder Zinn oder Kohlenstoff, und auch gegebenenfalls Verunreinigungen und auch Störstellen umfasst sind. Folglich bedeutet beispielsweise "besteht aus GaAs", dass als III-V Elementen ausschließlich Gallium und Arsen jedoch nicht In oder Al oder P usw. eingebaut sind.

Der Ausdruck "umfasst" bedeutet entsprechend, dass GaAs enthalten ist und weitere III-V Elemente, wie beispielsweise Phosphor, Aluminium oder Indium, zusätzlich zu eventuellen Dotierstoffen und/oder Verunreinigungen und/oder Störstellen enthalten sein können.

Die metallischen Anschlusskontakte bestehen in einer ersten alternativen Ausführungsform aus einer oder mehreren Metallschichten, z.B. Au und/oder Ag und/oder Pb und/oder Ge umfassende Schichten.

Der metallische Vorderseitenanschlusskontakt ist in Ausführungsformen flächig oder fingerförmig oder punktförmig ausgebildet, wobei angemerkt wird, dass ein flächiger, beispielsweise schichtförmig die Unterseite des Absorptionsgebiets bedeckender Vorderseitenanschlusskontakt eine möglichst geringe Schichtdicke, insbesondere eine Schichtdicke von 5 nm - 2 µm oder von 10 nm - 1 µm aufweist, um eine Absorption von Röntgenstrahlen klein zu halten.

Der Vorderseitenanschlusskontakt ist in einer anderen Ausführungsform stoffschlüssig mit der Unterseite des Absorptionsgebiets bzw., wenn vorhanden, stoffschlüssig mit der Unterseite der Halbleiterkontaktschicht verbunden.

Alternativ ist der Vorderseitenanschlusskontakt stoffschlüssig mit einer zwischen dem Vorderseitenanschlusskontakt und dem Absorptionsgebiet angeordneten weiteren Halbleiterschicht verbunden.

Die weitere Halbleiterschicht ist beispielsweise eine hochdotierte Halbleiterkontaktschicht mit Schichtdicken zwischen 1 µm bis 50 µm oder zwischen 1 µm - 20 µm.

Es sei angemerkt, dass der matrixartige Röntgendetektor vorzugsweise einen kreisförmigen oder viereckigen, insbesondere rechteckigen oder quadratischen, Umfang aufweist, wobei ein Vereinzeln vorzugsweise durch Sägen erfolgt.

Weiter versteht es sich, dass der erste Leitfähigkeitstyp n ist und der zweite Leitfähigkeitstyp p ist oder dass der erste Leitfähigkeitstyp p ist und der zweite Leitfähigkeitstyp n ist.

Der III-V-Halbleiterpixel-Röntgendetektor ist somit als n-auf-p oder als p-auf-n Struktur ausgebildet.

Der Mindestabstand der Halbleiterpassivierungsschicht dient zusammen mit der Halbleiterpassivierungsschicht selbst der Unterdrückung von Leckströmen.

Durch den bestehenden Abstand zwischen der Passivierungsschicht und dem Halbleiterkontaktgebiet, treten auch bei hohen Sperrspannungen oberhalb von 400 V nur besonders niedrige Sperrströme von kleiner 1 µA auf. Insbesondere liegen die Sperrströme in einem Bereich zwischen 0,5 nA und 50 nA oder unterhalb von 100 nA.

Vorzugsweise beträgt der Mindestabstand zu den Halbleiterkontaktschichten mindestens 50% oder mindestens 75% der Schichtdicke des Absorptionsgebiets.

Vorteile der erfindungsgemäßen Halbleiterdetektorstruktur sind ein besonders geringer Sperrstrom und eine hohe Durchbruchspannung. Insbesondere weist die Durchbruchkennlinie einen nahezu idealen Verlauf auf. Der besonders niedrige Sperrstrom ermöglicht das Anlegen hoher Rückwärtsspannungen, wodurch eine sehr hohe Empfindlichkeit erreicht wird.

Untersuchungen haben gezeigt, dass die Durchbruchspannung auch von dem Mindestabstand zwischen der Halbleiterpassivierungsschicht und den Halbleiterkontaktgebieten bestimmt wird. Mit dem erfindungsgemäßen Röntgendetektor lassen sich Durchbruchfeldstärken von bis zu 40 V/µm und sehr zuverlässig Durchbruchfeldstärken von über 30 V/µm erreichen.

III-V-Materialien, insbesondere GaAs, ermöglichen aufgrund einer hohen Ladungsträgerbeweglichkeit zusätzlich eine besonders empfindliche bzw. effiziente Detektion von Röntgenstrahlen, insbesondere von niederenergetischen Röntgenstrahlen.

Ein Vorteil des erfindungsgemäßen Röntgendetektors ist daher die große Empfindlichkeit, wodurch eine Reduktion der notwenigen Dosis, der beispielsweise ein Patient ausgesetzt werden muss, möglich ist.

Ebenso ist aufgrund der hohen Beweglichkeit der Ladungsträger nur eine sehr kurze Zeit pro Bildaufnahme nötig, was zu einer geringen Strahlenbelastung führt. Weiterhin ermöglicht die hohe Ladungsträgerbeweglichkeit farbiges Röntgen basierend auf "Photon Counting".

Das erfindungsgemäße Bauelement ist außerdem in verhältnismäßig wenigen Prozessschritten und dadurch relativ kostengünstig oder zumindest mit vertretbaren Kosten herstellbar.

In einer weiteren Ausführungsform ist zwischen dem Absorptionsgebiet und jedem Halbleiterkontaktgebiet jeweils eine Zwischenschicht des zweiten Leitfähigkeitstyps ausgebildet, wobei die Halbleiterpassivierungsschicht zu jeder Zwischenschicht entlang der Oberseite des Absorptionsgebiets den Mindestabstand aufweist.

Ist die Halbleiterkontaktschicht unterhalb des Absorptionsgebiets vorhanden, so ist In einer anderen Weiterbildung zwischen dem Absorptionsgebiets und der Halbleiterkontaktschicht eine Zwischenschicht des ersten Leitfähigkeitstyps ausgebildet.

Die Zwischenschichten weisen jeweils vorzugsweise eine geringere Dotierstoffkonzentration als der angrenzenden Halbleiterkontaktbereich, also das Halbleiterkontaktgebiets bzw. die Halbleiterschicht, auf.

Außerdem werden die Zwischenschichten jeweils vorzugsweise auf dieselbe Weise erzeugt, wie das Halbleiterkontaktgebiet bzw. die Halbleiterkontaktschicht, also beispielsweise durch Implantation oder als Mesa-Struktur durch Abscheide- und Ätzprozesse bzw. als epitaktische Schicht.

Es versteht sich, dass sich die Zwischenschichten nicht ausschließen. Der III-V-Halbleiterpixel-Röntgendetektor kann eine der beiden Zwischenschichten oder auch beide Zwischenschichten aufweisen.

In einer anderen Ausführungsform weist das Absorptionsgebiet eine Dotierstoffkonzentration von 8•10¹¹ - 1•10¹⁴ cm⁻³, also eine geringe Dotierung, und/oder eine Schichtdicke von 80 µm - 2000 µm oder von 500 µm - 2000 µm oder von 900 µm - 2000 µm auf.

Mit dem besonders tiefen Absorptionsgebiet zur Absorption und der durch die beabstandete Halbleiterpassivierungsschicht besonders hohen Sperrspannung eignet sich die erfindungsgemäße Halbleiterstruktur besonders zur Strahlungsdetektion.

Die Halbleiterkontaktgebiete weisen jeweils vorzugsweise eine Dotierstoffkonzentration von mindestens 5•10¹⁸ cm⁻³ auf, sind also hochdotiert.

In einer Weiterbildung beträgt der Mindestabstand mindestens 50 µm oder mindestens 100 µm oder mindestens 1000 µm.

In einer anderen Weiterbildung weisen die Halbleiterkontaktgebiete jeweils von Mitte zu Mitte einen Abstand von mindestens 20 µm oder von mindestens 50 µm auf.

Es versteht sich, dass der Abstand der Halbleiterkontaktgebiete den Pixelabstand bzw. Bildpunktabstand bzw. Pixel-Pitch vorgibt. Vorzugsweise ist der Abstand auf eine Auswerteeinheit abgestimmt, insbesondere um mittels Flip-Chip-Technologie mit einer entsprechenden Auswerteeinheit verbunden werden zu können.

In einer weiteren Ausführungsform weist die Halbleiterpassivierungsschicht eine Schichtdicke von 0,1 µm - 1 µm auf. Außerdem umfasst die Halbleiterpassivierungsschicht eine Verbindung aus InGaP und / oder AlGaAs und/oder InGaAsP auf oder besteht aus AlGaAs oder aus InGaP oder aus InGaAsP.

In einer anderen Weiterbildung umschließt die Halbleiterpassivierungsschicht in einer Projektion senkrecht zu der Oberseite des Absorptionsgebiets die Halbleiterkontaktgebiete oder zumindest einige der Halbleiterkontaktgebiete jeweils vollständig.

In einer weiteren Weiterbildung weisen die Halbleiterkontaktgebiete und das Absorptionsgebiet jeweils GaAs auf oder bestehen aus GaAs.

Die Erfindung wird nachfolgend unter Bezugnahme auf die Zeichnungen näher erläutert. Hierbei werden gleichartige Teile mit identischen Bezeichnungen beschriftet.

Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt einer ersten Ausführungsform eines III-V-Halbleiterpixel-Röntgendetektors,
- Figur 2: einen Querschnitt einer zweiten Ausführungsform des III-V-Halbleiterpixel-Röntgendetektors,
- Figur 3: eine Aufsicht auf eine weitere Ausführungsform des III-V-Halbleiterpixel-Röntgendetektors,
- Figur 4: eine Aufsicht auf eine weitere Ausführungsform des III-V-Halbleiterpixel-Röntgendetektors,
- Figur 5: einen Querschnitt einer weiteren Ausführungsform eines III-V-Halbleiterplxels des Röntgendetektors,
- Figur 6: einen Querschnitt einer weiteren Ausführungsform des III-V-Halbleiterpixel-Röntgendetektors,
- Figur 7: einen Querschnitt einer weiteren Ausführungsform des III-V-Halbleiterpixel-Röntgendetektors.

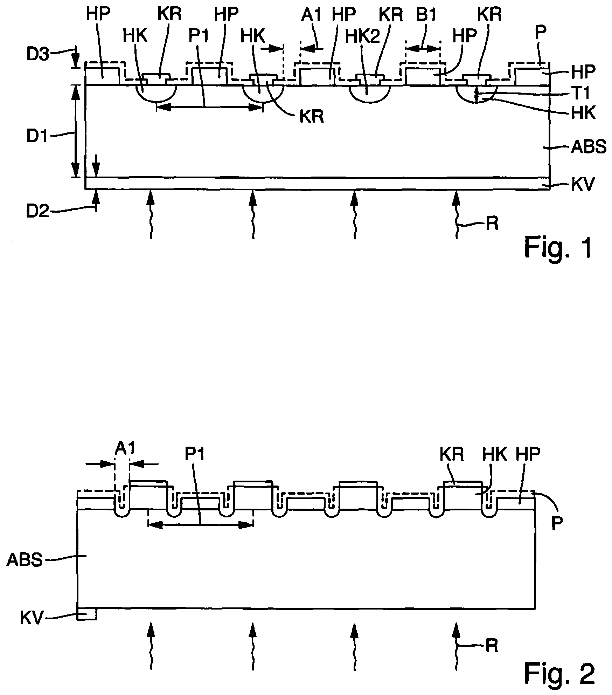

Die Abbildung der Figur 1 zeigt einen Querschnitt einer ersten erfindungsgemäßen Ausführungsform eines III-V-Halbleiterpixel-Röntgendetektors zur Detektion von Röntgenstrahlen R.

Der Röntgendetektor weist eine Matrix von vier mal vier III-V-Halbleiterpixel auf. Es sei angemerkt, dass die Matrix in einer nicht dargestellten Ausführungsform drei mal drei III-V-Halbleiterpixel aufweist. Es versteht sich, dass in einer anderen nicht dargestellten Ausführungsform der Röntgendetektor mehr als sechszehn III-V-Halbleiterpixel aufweist.

Die Halbleiterpixel umfassen ein gemeinsames Absorptionsgebiet ABS mit einer Unterseite, einer Oberseite und einer Schichtdicke D1 sowie einen gemeinsamen Vorderseitenanschlusskontakt KV, wobei der Vorderseitenanschlusskontakt als Metallschicht mit möglichst geringer Schichtdicke D2 ausgebildet ist und die Unterseite des Absorptionsgebiets ABS bedeckt und mit der Unterseite des Absorptionsgebiets ABS stoffschlüssig verbunden ist.

Jeder Halbleiterpixel umfasst außerdem ein Halbleiterkontaktgebiet HK, wobei die Halbleiterkontaktgebiete HK sich jeweils von einer Oberseite wannenförmig bis zu einer Tiefe T1 in das Absorptionsgebiet ABS hinein erstrecken. Benachbarte Halbeiterkontaktgebiete HK weisen von Mitte zu Mitte einen Abstand P1 auf, wobei der Abstand P1 dem Pixel Pitch bzw. dem Bildpunktabstand entspricht.

Zwischen den Halbleiterkontaktgebieten HK ist auf der Oberseite des Absorptionsgebiets ABS jeweils eine Halbleiterpassivierungsschicht HP mit einer Schichtdicke D3 angeordnet, wobei die Halbleiterpassivierungsschicht HP mit der Oberseite des Absorptionsgebiets ABS stoffschlüssig verbunden ist und zu jedem der Halbleiterkontaktgebiete jeweils einen Mindestabstand A1 von mindestens 2 µm aufweist.

Eine Oberseite der Halbleiterpassivierungsschicht HP sowie ein zwischen der Halbleiterpassivierungsschicht HP und dem Halbleiterkontaktgebieten HK liegender Teilbereich der Oberseite des Absorptionsgebiets ABS und jeweils ein an die Oberseite des Absorptionsgebiets angrenzender Randbereich der Halbleiterkontaktgebiete HK ist optional von einer weiteren Passivierungsschicht P, z.B. einer dünnen Siliziumnitrid oder Oxidschicht bedeckt (gestrichelt dargestellt).

Auf der Oberseite jedes Halbleiterkontaktgebiets HK ist jeweils ein Rückseitenanschlusskontakt KR angeordnet, wobei sich jeder Rückseitenanschlusskontakt KR jeweils auch über einen angrenzenden Bereich der weiteren Passivierungsschicht P erstreckt, wenn die weitere Passivierungsschicht P vorhanden ist und mit der jeweiligen Oberseite des Halbleiterkontaktgebiets HK und gegebenenfalls der weiteren Passivierungsschicht P stoffschlüssig verbunden ist.

In der Abbildung der Figur 2 ist eine weitere Ausführungsform dargestellt. Im Folgenden werden nur die Unterschiede zu der Abbildung der Figur 1 erläutert.

Die Halbleiterkontaktgebiete HK sind jeweils als Mesa-Struktur auf einem jeweiligen Teilbereich der Oberseite des Absorptionsgebiets ABS angeordnet, wobei die Rückseitenanschlusskontakte KR jeweils flächig auf eine Oberseite der jeweiligen Mesa-Struktur ausgebildet sind.

Der Röntgendetektor weist keine weitere Passivierungsschicht P auf. Der gemeinsame Rückseitenanschlusskontakt RK ist punktförmig bzw. nur auf einem kleinen Teilbereich der Unterseite des Absorptionsgebiets ABS ausgebildet.

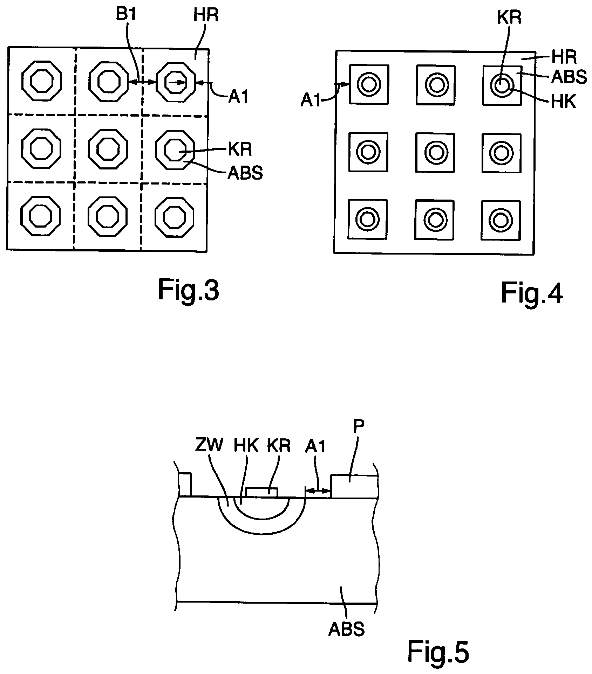

In der Abbildung der Figur 3 ist eine Aufsicht auf eine weitere Ausführungsform des Röntgendetektors ausgebildet.

Der Röntgendetektor weist dreimal drei III-V-Halbleiterpixel auf, wobei jeder Pixel ein als Mesa-Struktur ausgebildetes Halbleiterkontaktgebiet HK mit einem achteckigen Umfang und einer von dem jeweiligen Rückseitenanschlusskontakt KR bedeckten Oberseite aufweist.

Die Halbleiterpassivierungsschicht HP umschließt jedes Halbleiterkontaktgebiet HK vollständig in dem Mindestabstand A1, so dass um jedes Halbleiterkontaktgebiet HK ein Teilbereich der Oberseite des Absorptionsgebiets frei liegt.

In der Abbildung der Figur 3 ist eine Aufsicht einer weiteren Ausführungsform dargestellt. Im Folgenden werden nur die Unterschiede zu der Abbildung der Figur 3 erläutert.

Die Halbleiterkontaktgebiet HK sind jeweils durch Implantation wannenförmig und mit kreisförmiger Oberseite in dem gemeinsamen Absorptionsgebiet ABS ausgebildet. Die Rückseitenanschlusskontakte RK weisen ebenfalls einen kreisförmigen Umfang auf.

Die Halbleiterpassivierungsschicht HP weist im Bereich jedes Halbleiterkontaktgebiets HK eine quadratische Ausnehmung auf, wobei der Rand der Ausnehmung zu dem jeweiligen Halbleiterkontaktgebiet immer mindestens den Mindestabstand A1 aufweist.

In der Abbildung der Figur 5 ist eine weitere Ausführungsform eines Ausschnitts eines III-V-Halbleiterpixel-Röntgendetektors dargestellt. Im Folgenden werden nur die Unterschiede zu der Abbildung der Figur 1 erläutert.

Der III-V-Halbleiterpixel-Röntgendetektor weist zwischen jedem Halbleiterkontaktgebiet HK und dem gemeinsamen Absorptionsgebiet ABS jeweils eine Zwischenschicht ZW auf, wobei die Zwischenschicht einen mit den Halbleiterkontaktgebieten übereinstimmenden Leitfähigkeitstyp und eine im Vergleich zu der Dotierstoffkonzentration der Halbleiterkontaktgebiete geringeren Dotierstoffkonzentration aufweist.

Die Halbleiterpassivierungsschicht HP weist zu der Zwischenschicht ZW entlang der Oberseite des Absorptionsgebiets den Mindestabstand A1 auf.

Die Rückseitenanschlusskontakte KR sind jeweils auf einem Teilbereich der Oberseite des jeweiligen Halbleiterkontaktgebiets HK ausgebildet. Eine weitere Passivierungsschicht P weist der Röntgendetektor nicht auf.

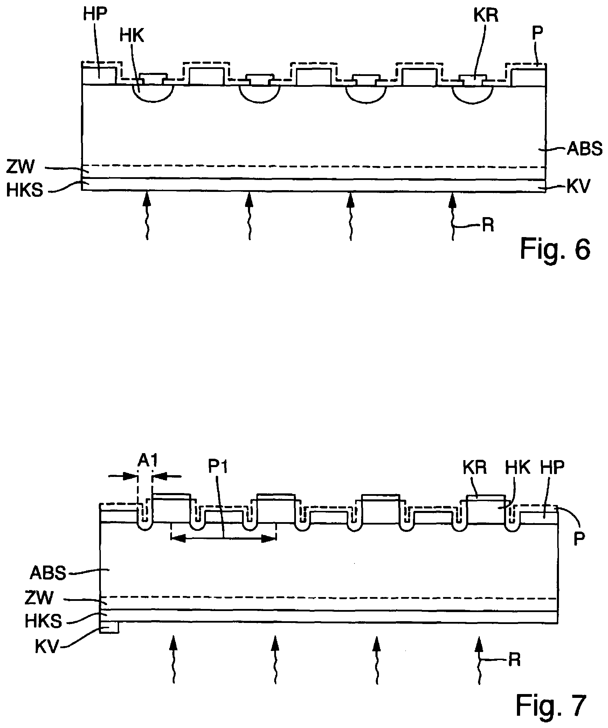

In den Abbildungen der Figuren 6 ist jeweils eine weitere Ausführungsform eines Ausschnitts eines III-V-Halbleiterpixel-Röntgendetektors dargestellt. Im Folgenden werden nur die Unterschiede zu der Abbildung der Figur 1 bzw. der Abbildung der Figur 2 erläutert.

Der III-V-Halbleiterpixel-Röntgendetektor weist zwischen dem Absorptionsgebiet ABS und dem Vorderseitenanschlusskontakt KV eine hochdotierte Halbleiterkontaktschicht HKS des ersten Leitfähigkeitstyps auf, wobei eine Oberseite der Halbleiterkontaktschicht HKS stoffschlüssig mit der Unterseite des Absorptionsgebiets ABS und eine Unterseite stoffschlüssig mit dem Vorderseitenanschlusskontakt KV verbunden ist.

Optional (jeweils gestrichelt eingezeichnet) ist zwischen der Halbleiterkontaktschicht HKS und dem Absorptionsgebiet eine Zwischenschicht ZW des ersten Leitfähigkeitstyps angeordnet, wobei die Oberseite der Halbleiterkontaktschicht HKS stoffschlüssig mit der Zwischenschicht ZW verbunden ist und die Zwischenschicht ZW eine niedrigere Dotierstoffkonzentration als die Halbleiterkontaktschicht HKS aufweist.

In den Ausführungsbeispielen der Figuren 6 und 7 weist das Absorptionsgebiet ABS entweder den ersten oder den zweiten Leitfähigkeitstyp auf, so dass sich der p-n Übergang entweder zwischen den Halbleiterkontaktgebieten HK und dem Absorptionsgebiet oder zwischen der Halbleiterkontaktschicht HKS und dem Absorptionsgebiet ausbildet.

## Patentansprüche

1. III-V-Halbleiterpixel-Röntgendetektor, aufweisend
- ein Absorptionsgebiet (ABS) eines ersten Leitfähigkeitstyps mit einer Oberseite und einer Unterseite,
- mindestens neun in einer Matrix entlang der Oberseite des Absorptionsgebiets (ABS) angeordnete Halbleiterkontaktgebiete (HK) eines zweiten Leitfähigkeitstyps und mit einer ersten Energiebandlücke, wobei
- ein metallischer Vorderseitenanschlusskontakt (KV) unterhalb der Unterseite des Absorptionsgebiets (ABS) angeordnet ist und
- oberhalb jedes Halbleiterkontaktgebiets (HK) jeweils ein metallischer Rückseitenanschlusskontakt (KR) angeordnet ist,
- die Halbleiterkontaktgebiete (HK) und das Absorptionsgebiet (ABS) GaAs aufweisen oder aus GaAs bestehen,
der Röntgendetektor eine Halbleiterpassivierungsschicht (HP) des ersten oder des zweiten Leitfähigkeitstyps aufweist,
**dadurch gekennzeichnet, dass**
der Röntgendetektor eine sich von der ersten Energiebandlücke unterscheidenden zweiten Energiebandlücke aufweist, wobei
- die Halbleiterpassivierungsschicht (HP) und das Absorptionsgebiet (ABS) zueinander gitterangepasst sind,
- die Halbleiterpassivierungsschicht (HP) gebietsweise auf der Oberseite des Absorptionsgebiets (ABS) angeordnet ist und
- die Halbleiterpassivierungsschicht (HP) zu jedem Halbeiterkontaktgebiet (HK) entlang der Oberseite des Absorptionsgebiets (ABS) einen Mindestabstand (A1) von mindestens 2 µm oder von mindestens 10 µm oder von mindestens 20 µm oder von mindestens 40 µm aufweist.

2. III-V-Halblelterplxel-Röntgendetektor, aufweisend
- ein Absorptionsgebiet (ABS) eines ersten oder eines zweiten Leitfähigkeitstyps mit einer Oberseite und einer Unterseite,
- mindestens neun in einer Matrix entlang der Oberseite des Absorptionsgebiets (ABS) angeordnete Halbleiterkontaktgebiete (HK) des zweiten Leitfähigkeitstyps und mit einer ersten Energiebandlücke,
- eine Halbleiterkontaktschicht (HKS) des ersten Leitfähigkeitstyps, wobei
- die Halbleiterkontaktschicht (HKS) unterhalb der Unterseite des Absorptionsgebiets (ABS) angeordnet ist,
- ein metallischer Vorderseitenanschlusskontakt (KV) unterhalb einer Unterseite der Halbleiterkontaktschicht (HKS) angeordnet ist und
- oberhalb jedes Halbleiterkontaktgebiets (HK) jeweils ein metallischer Rückseitenanschlusskontakt (KR) angeordnet ist,
das Absorptionsgebiet (ABS) GaAs aufweist oder aus GaAs besteht,
- der Röntgendetektor eine Halbleiterpassivierungsschicht (HP) des ersten oder des zweiten Leitfähigkeitstyps und mit einer sich von der ersten Energiebandlücke unterscheidenden zweiten Energiebandlücke aufweist, wobei
- die Halbleiterpassivierungsschicht (HP) und das Absorptionsgebiet (ABS) zueinander gitterangepasst sind,
- die Halbleiterpassivierungsschicht (HP) gebietsweise auf der Oberseite des Absorptionsgebiets (ABS) angeordnet ist, und
- die Halbleiterpassivierungsschicht (HP) zu jedem Halbeiterkontaktgebiet (HK) entlang der Oberseite des Absorptionsgebiets (ABS) einen Mindestabstand (A1) von mindestens 2 µm oder von mindestens 10 µm oder von mindestens 20 µm oder von mindestens 40 µm aufweist.

3. III-V-Halbleiterpixel-Röntgendetektor nach Anspruch 2, **dadurch gekennzeichnet, dass** die Halbleiterkontaktschicht (HKS) eine Dotierstoffkonzentration von mindestens 1•10¹⁷ cm ⁻³ und eine Schichtdicke von 0,5 µm - 150 µm oder von 0,5 µm - 50 µm oder von 0,5 µm - 10 µm oder von 0,5 µm - 5 µm aufweist.

4. III-V-Halbleiterpixel-Röntgendetektor nach Anspruch 2 oder 3, **dadurch gekennzeichnet, dass** zwischen dem Absorptionsgebiet (ABS) und der Halbleiterkontaktschicht (HKS) eine Zwischenschicht (ZWS) des ersten Leitfähigkeitstyps ausgebildet ist.

5. III-V-Halbleiterpixel-Röntgendetektor nach einem der vorstehenden Ansprüche, **dadurch gekennzeichnet, dass** zwischen dem Absorptionsgebiet (ABS) und jedem Halbleiterkontaktgebiet (HK) jeweils eine Zwischenschicht (ZW) des zweite Leitfähigkeitstyps ausgebildet ist, wobei die Halbleiterpassivierungsschicht (HP) zu jeder Zwischenschicht (ZW) entlang der Oberseite des Absorptionsgebiets (ABS) den Mindestabstand (A1) aufweist.

6. III-V-Halbleiterpixel-Röntgendetektor nach einem der vorstehenden Ansprüche, **dadurch gekennzeichnet, dass** das Absorptionsgebiet (ABS) eine Dotierstoffkonzentration von 8•10¹¹ - 1•10¹⁴ cm⁻³ und/oder eine Schichtdicke von 80 µm - 2000 µm oder von 500 µm - 2000 µm oder von 900 µm - 2000 µm aufweist.

7. III-V-Halbleiterpixel-Röntgendetektor nach einem der vorstehenden, **dadurch gekennzeichnet, dass** die Halbleiterkontaktgebiete (HK) jeweils eine Dotierstoffkonzentration von mindestens 5•10¹⁸ cm⁻³ aufweisen.

8. III-V-Halbleiterpixel-Röntgendetektor nach einem der vorstehenden Ansprüche, **dadurch gekennzeichnet, dass** sich die Halbleiterkontaktgebiete (HK) jeweils von wannenförmig in das Absorptionsgebiet (ABS) hinein erstrecken.

9. III-V-Halbleiterpixel-Röntgendetektor nach einem der Ansprüche 1 bis 7, **dadurch gekennzeichnet, dass** die Halbleiterkontaktgebiete (HK) jeweils als Mesa-Struktur oberhalb der Oberseite des Absorptionsgebiets (ABS) angeordnet sind.

10. III-V-Halbleiterpixel-Röntgendetektor nach einem der vorstehenden Ansprüche, **dadurch gekennzeichnet, dass** der Mindestabstand (A1) mindestens 50 µm oder mindesten 100 µm oder mindestens 1000 µm beträgt.

11. III-V-Halbleiterpixel-Röntgendetektor nach einem der vorstehenden Ansprüche, **dadurch gekennzeichnet, dass** die Halbleiterkontaktgebiete (HK) jeweils von Mitte zu Mitte einen Abstand von mindestens 20 µm oder von mindestens 50 µm aufweisen.

12. III-V-Halbleiterpixel-Röntgendetektor nach einem der vorstehenden Ansprüche, **dadurch gekennzeichnet, dass** die Halbleiterpassivierungsschicht (HP) eine Schichtdicke (D3) von 0,1 µm - 1 µm aufweist.

13. III-V-Halbleiterpixel-Röntgendetektor nach einem der vorstehenden Ansprüche, **dadurch gekennzeichnet, dass** die Halbleiterpassivierungsschicht (HP) InGaP und/oder AlGaAs und/oder InGaAsP aufweist oder aus InGaP oder AlGaAs oder InGaAsP besteht.

14. III-V-Halbleiterpixel-Röntgendetektor nach einem der vorstehenden Ansprüche, **dadurch gekennzeichnet, dass** die Halbleiterpassivierungsschicht (HP) in einer Projektion senkrecht zu der Oberseite des Absorptionsgebiets (ABS) die Halbleiterkontaktgebiete (HK) oder zumindest einige der Halbleiterkontaktgebiete (HK) jeweils vollständig umschließt,

15. III-V-Halbleiterpixel-Röntgendetektor nach einem der vorstehenden Ansprüche, **dadurch gekennzeichnet, dass** soweit vorhanden die Halbleiterkontaktschicht (HKS) jeweils GaAs aufweisen oder aus GaAs bestehen.

## Claims

1. III-V semiconductor pixel X-ray detector, comprising
- an absorption region (ABS) of a first conductivity type with an upper side and a lower side,
- at least nine semiconductor contact regions (HK), which are arranged in a matrix along the upper side of the adsorption region (ABS), of a second conductivity type and with a first energy band gap, wherein
- a metallic front side terminal contact (KV) is arranged below the lower side of the absorption region (ABS) and
- a respective metallic rear side terminal contact (KR) is arranged above each semiconductor contact region (HK),
- the semiconductor contact regions (HK) and the absorption region (ABS) comprise GaAs or consist of GaAs,
- the X-ray detector comprises a semiconductor passivation layer (HP) of the first or second conductivity type,
**characterised in that**
- the X-ray detector has a second energy band gap different from the first energy band gap, wherein
- the semiconductor passivation layer (HP) and the absorption region (ABS) are adapted in lattice to one another,
- the semiconductor passivation layer (HP) is arranged regionally on the upper side of the absorption region (ABS) and
- the semiconductor passivation layer (HP) has from each semiconductor contact region (HK) along the upper side of the absorption region (ABS) a minimum spacing (A1) of at least 2 µm or of at least 10 µm or of at least 20 µm or of at least 40 µm.

2. III-V semiconductor pixel X-ray detector, comprising
- an absorption region (ABS) of a first or a second conductivity type with an upper side and a lower side,
- at least nine semiconductor contact regions (HK), which are arranged in a matrix along the upper side of the adsorption region (ABS), of the second conductivity type and with a first energy band gap,
- a semiconductor contact layer (HKS) of the first conductivity type, wherein
- the semiconductor contact layer (HKS) is arranged below the lower side of the absorption region (ABS),
- a metallic front side terminal contact (KV) is arranged below a lower side of the absorption region (ABS) and
- a respective metallic rear side terminal contact (KR) is arranged above each semiconductor contact region (HK),
- the semiconductor contact region (HK) comprises GaAs or consists of GaAs,
- the X-ray detector comprises a semiconductor passivation layer (HP) of the first or second conductivity type and has a second energy band gap differing from the first energy band gap, wherein
- the semiconductor passivation layer (HP) and the absorption region (ABS) are adapted in lattice to one another,
- the semiconductor passivation layer (HP) is arranged regionally on the upper side of the absorption region (ABS) and
- the semiconductor passivation layer (HP) has from each semiconductor contact region (HK) along the upper side of the absorption region (ABS) a minimum spacing (A1) of at least 2 µm or of at least 10 µm or of at least 20 µm or of at least 40 µm.

3. III-V semiconductor pixel X-ray detector according to claim 2, **characterised in that** the semiconductor contact layer (HKS) has a dopant concentration of at least 1•10¹⁷ cm⁻³ and a layer thickness of 0.5 µm - 150 µm or of 0.5 µm - 50 µm or of 0.5 µm - 10 µm or of 0.5 µm - 5 µm.

4. III-V semiconductor pixel X-ray detector according to claim 2 or 3, **characterised in that** an intermediate layer (ZWS) of the first conductivity type is formed between the absorption region (ABS) and the semiconductor contact layer (HKS).

5. III-V semiconductor pixel X-ray detector according to any one of the preceding claims, **characterised in that** a respective intermediate layer (ZW) of the second conductivity type is formed between the absorption region (ABS) and each semiconductor contact region (HK), wherein the semiconductor passivation layer (HP) has the minimum spacing (A1) from each intermediate layer (ZW) along the upper side of the absorption region (ABS).

6. III-V semiconductor pixel X-ray detector according to any one of the preceding claims, **characterised in that** the absorption region (ABS) has a dopant concentration of 8•10¹¹ - 1•10¹⁴ cm⁻³ and/or a layer thickness of 80 µm - 2000 µm or of 500 µm - 2000 µm or of 900 µm - 2000 µm.

7. III-V semiconductor pixel X-ray detector according to any one of the preceding claims, **characterised in that** the semiconductor contact regions (HK) each have a dopant concentration of at least 5•10¹⁸ cm⁻³.

8. III-V semiconductor pixel X-ray detector according to any one of the preceding claims, **characterised in that** the semiconductor contact regions (HK) each extend by trough-shape into the absorption region (ABS).

9. III-V semiconductor pixel X-ray detector according to any one of claims 1 to 7, **characterised in that** the semiconductor contact regions (HK) are each arranged as a mesa structure above the upper side of the absorption region (ABS).

10. III-V semiconductor pixel X-ray detector according to any one of the preceding claims, **characterised in that** the minimum spacing (A1) is at least 50 µm or at least 100 µm or at least 1000 µm.

11. III-V semiconductor pixel X-ray detector according to any one of the preceding claims, **characterised in that** the semiconductor contact regions (HK) respectively have a centre-to-centre spacing of at least 20 µm or of at least 50 µm.

12. III-V semiconductor pixel X-ray detector according to any one of the preceding claims, **characterised in that** the semiconductor passivation layer (HP) has a layer thickness (D3) of 0.1 µm - 1 µm.

13. III-V semiconductor pixel X-ray detector according to any one of the preceding claims, **characterised in that** the semiconductor passivation layer (HP) comprises InGaP and/or AlGaAs and/or InGaAsP or consists of IGaP or AlGaAS or InGaAsP.

14. III-V semiconductor pixel X-ray detector according to any one of the preceding claims, **characterised in that** the semiconductor passivation layer (HP) in a projection perpendicular to the upper side of the absorption region (ABS) respectively fully encloses the semiconductor contact regions (HK) or at least one of the semiconductor contact regions (HK).

15. III-V semiconductor pixel X-ray detector according to any one of the preceding claims, **characterised in that** insofar as present the semiconductor contact layer (HKS) respectively comprises GaAs or consists of GaAs.

## Revendications

1. Détecteur de rayons X à pixels semi-conducteurs III-V, comprenant
- une zone d'absorption (ABS) d'un premier type de conductivité avec une face supérieure et une face inférieure,
- au moins neuf zones de contact semi-conductrices (HK) d'un deuxième type de conductivité disposées en matrice le long de la face supérieure de la zone d'absorption (ABS) et présentant une première bande interdite,
- un contact métallique de connexion avant (KV) étant disposé sous la face inférieure de la zone d'absorption (ABS) et
- un contact métallique de connexion arrière (KR) étant disposé au-dessus de chaque zone de contact semi-conductrice (HK),
- les zones de contact semi-conductrices (HK) et la zone d'absorption (ABS) comportent du GaAs ou sont constituées de GaAs,
le détecteur à rayons X comportant une couche de passivation semi-conductrice (HP) du premier ou du deuxième type de conductivité,
**caractérisé en ce que**
le détecteur de rayons X présente une deuxième bande interdite différente de la première bande interdite,
- la couche de passivation semi-conductrice (HP) et la zone d'absorption (ABS) sont alignées l'une par rapport à l'autre au niveau du réseau cristallin,
- la couche de passivation semi-conductrice (HP) est disposée par zones sur la face supérieure de la zone d'absorption (ABS) et
- la couche de passivation semi-conductrice (HP) présente, par rapport à chaque zone de contact semi-conductrice (HK) le long de la face supérieure de la zone d'absorption (ABS), une distance minimale (A1) d'au moins 2 µm ou d'au moins 20 µm ou d'au moins 40 µm.

2. Détecteur à rayons X à pixels semi-conducteurs III-V, présentant
- une zone d'absorption (ABS) d'un premier ou d'un deuxième type de conductivité avec une face supérieure et une face inférieure,
- au moins neuf zones de contact semi-conductrices (HK) du deuxième type de conductivité, disposées en matrice le long de la face supérieure de la zone d'absorption (ABS) et présentant une première bande interdite,
- une couche de contact semi-conductrice (HKS) du premier type de conductivité,
- la couche de contact semi-conductrice (HKS) étant disposée sous la face inférieure de la zone d'absorption (ABS),
- un contact métallique de connexion avant (KV) étant disposé sous une face inférieure de la couche de contact semi-conductrice (HKS) et
- un contact métallique de connexion arrière (KR) étant disposé au-dessus de chaque zone de contact semi-conductrice (HK),
la zone d'absorption (ABS) comportant du GaAs ou étant constituée de GaAs,
- le détecteur à rayons X comportant une couche de passivation semi-conductrice (HP) du premier ou du deuxième type de conductivité et avec une deuxième bande interdite différente de la première bande interdite,
- la couche de passivation semi-conductrice (HP) et la zone d'absorption (ABS) étant alignées l'une par rapport à l'autre au niveau du réseau cristallin,
- la couche de passivation semi-conductrice (HP) étant disposée par zones sur la face supérieure de la zone d'absorption (ABS), et
- la couche de passivation semi-conductrice (HP) présentant, par rapport à chaque zone de contact semi-conductrice (HK) le long de la face supérieure de la zone d'absorption (ABS), une distance minimale (A1) d'au moins 2 µm ou d'au moins 10 µm ou d'au moins 20 µm ou d'au moins 40 µm.

3. Détecteur à rayons X à pixels semi-conducteurs III-V selon la revendication 2, **caractérisé en ce que** la couche de contact semi-conductrice (HKS) présente une concentration en dopant d'au moins 1•10¹⁷ cm⁻³ et une épaisseur de couche de 0,5 µm - 150 µm ou de 0,5 µm - 50 µm ou de 0,5 µm - 10 µm ou de 0,5 µm - 5 µm.

4. Détecteur de rayons X à pixels semi-conducteurs III-V selon la revendication 2 ou 3, **caractérisé en ce qu'**une couche intermédiaire (ZWS) du premier type de conductivité est formée entre la zone d'absorption (ABS) et la couche de contact semi-conductrice (HKS).

5. Détecteur de rayons X à pixels semi-conducteurs III-V selon l'une des revendications précédentes, **caractérisé en ce qu'**entre la zone d'absorption (ABS) et chaque zone de contact semi-conductrice (HK) est formée à chaque fois une couche intermédiaire (ZW) du deuxième type de conductivité, la couche de passivation semi-conductrice (HP) présentant, par rapport à chaque couche intermédiaire (ZW) le long de la face supérieure de la zone d'absorption (ABS), la distance minimale (A1).

6. Détecteur à rayons X à pixels semi-conducteurs III-V selon l'une des revendications précédentes, **caractérisé en ce que** la zone d'absorption (ABS) présente une concentration en dopant de 8•10¹¹ - 1•10¹⁴ cm⁻³ et/ou une épaisseur de couche de 80 µm - 2000 µm ou de 500 µm à 2000 µm ou de 900 µm à 2000 µm.

7. Détecteur de rayons X à pixels semi-conducteurs III-V selon l'une des revendications précédentes, **caractérisé en ce que** les zones de contact semi-conductrices (HK) présentent chacune une concentration en dopant d'au moins 5•10¹⁸ cm⁻³.

8. Détecteur de rayons X à pixels semi-conducteurs III-V selon l'une des revendications précédentes, **caractérisé en ce que** les zones de contact semi-conductrices (HK) s'étendent chacune en forme de cuvette dans la zone d'absorption (ABS).

9. Détecteur de rayons X à pixels semi-conducteurs III-V selon l'une des revendications 1 à 7, **caractérisé en ce que** les zones de contact semi-conductrices (HK) sont chacune disposées sous forme de structure mesa au-dessus de la face supérieure de la zone d'absorption (ABS).

10. Détecteur à rayons X à pixels semi-conducteurs III-V selon l'une des revendications 1 à 7, **caractérisé en ce que** la distance minimale (Al) est d'au moins 50 µm ou d'au moins 100 µm ou d'au moins 1000 µm.

11. Détecteur de rayons X à pixels semi-conducteurs III-V selon l'une des revendications précédentes, **caractérisé en ce que** les zones de contact semi-conductrices (HK) présentent chacune une distance de centre à centre d'au moins 20 µm ou d'au moins 50 µm.

12. Détecteur de rayons X à pixels semi-conducteurs III-V selon l'une des revendications précédentes, **caractérisé en ce que** la couche de passivation semi-conductrice (HP) présente une épaisseur (D3) comprise entre 0,1 µm et 1 µm.

13. Détecteur de rayons X à pixels semi-conducteurs III-V selon l'une des revendications précédentes, **caractérisé en ce que** la couche de passivation semi-conductrice (HP) comprend de l'InGaP et/ou de l'AlGaAs et/ou de l'InGaAsP ou est constituée d'InGaP ou d'AlGaAs ou d'InGaAsP.

14. Détecteur de rayons X à pixels semi-conducteurs III-V selon l'une des revendications précédentes, **caractérisé en ce que** la couche de passivation semi-conductrice (HP) entoure complètement, dans une projection perpendiculaire à la face supérieure de la zone d'absorption (ABS), les zones de contact semi-conductrices (HK) ou au moins certaines des zones de contact semi-conductrices (HK).

15. Détecteur de rayons X à pixels semi-conducteurs III-V selon l'une des revendications précédentes, **caractérisé en ce que**, lorsqu'elles sont présentes, les couches de contact semi-conductrices (HKS) contiennent chacune du GaAs ou sont constituées de GaAs.
